# EUROPEAN PATENT SPECIFICATION

(11) **EP 1 335 801 B1**
(45) Date of publication and mention of the grant of the patent: **30.08.2006**
(21) Application number: 01997365.0
(22) Date of filing: 21.11.2001
(51) Int. Cl.: B08B 7/00

(54) **APPARATUS AND METHOD FOR REMOVING PARTICLES FROM SOLID-STATE SURFACES**
VORRICHTUNG UND VERFAHREN ZUR ENTFERNUNG VON FREMDKÖRPERN VON HALBLEITEROBERFLÄCHEN
APPAREIL ET MÉTHODE POUR L'ELIMINATION DE PARTICULES DE SURFACES DE SEMI-CONDUCTEURS

(30) Priority: 22.11.2000 US 721167
(43) Date of publication of application: 20.08.2003
(73) Proprietor: APPLIED MATERIALS, INC., Santa Clara, California 95052 (US); Uziel, Yoram, 20180 Mobile Post Misgav (IL); Yogev, David, 36811 Nesher (IL); Poles, Ehud, 25147 Kfar Vradim (IL); Wachs, Amir, 34756 Haifa (IL)
(72) Inventor: UZIEL, Yoram, 20180 Mobile Post Misgav (IL); YOGEV, David, 36811 Nesher (IL); POLES, Ehud, 25147 Kfar Vradim (IL); WACHS, Amir, 34756 Haifa (IL)
(74) Representative: Evens, Paul Jonathan
(86) International application number: PCT/IL2001/001073
(87) International publication number: WO 2002/042013

(56) References cited:
- EP-A- 0 764 478
- WO-A-00/38935
- US-A- 6 048 588
- PATENT ABSTRACTS OF JAPAN vol. 1998, no. 13, 30 November 1998 (1998-11-30) & JP 10 216664 A (NIKON CORP), 18 August 1998 (1998-08-18)

## Description

### FIELD OF THE INVENTION

The present invention relates generally to processing of semiconductor devices, and specifically to methods and apparatus for removal of foreign particles and contaminants from solid-state surfaces, such as semiconductor wafers and lithography masks.

### BACKGROUND OF THE INVENTION

Removal of particles and contaminants from solid state surfaces is a matter of great concern in integrated circuit manufacture. This concern includes, but is not limited to, semiconductor wafers, printed circuit boards, component packaging, and the like. As the trend to miniaturize electronic devices and components continues, and critical dimensions of circuit features become ever smaller, the presence of even a minute foreign particle on a substrate wafer during processing can cause a fatal defect in the circuit. Similar concerns affect other elements used in the manufacturing process, such as masks and reticules.

Various methods are known in the art for stripping and cleaning foreign matter from the surfaces of wafers and masks, while avoiding damage to the surface itself. For example, U.S. Patent 4,980,536 describes a method and apparatus for removal of particles from solid-state surfaces by laser bombardment. U.S. Patents 5,099,557 and 5,024,968 describe methods and apparatus for removing surface contaminants from a substrate by high-energy irradiation. The substrate is irradiated by a laser with sufficient energy to release the particles, while an inert gas flows across the wafer surface to carry away the released particles.

U.S. Patent 4,987,286 describes a method and apparatus for removing minute particles (as small as submicron) from a surface to which they are adhered. An energy transfer medium, typically a fluid; is interposed between each particle to be removed and the surface. The medium is irradiated with laser energy and absorbs sufficient energy to cause explosive evaporation, thereby dislodging the particles.

One particularly bothersome type of contamination that is found on semiconductor wafers and lithography masks is residues of photoresist left over from a preceding photolithography step. U.S. Patent 5,114,834 describes a process and system for stripping this photoresist using a high-intensity pulsed laser. The laser beam is swept over the entire wafer surface so as to ablate the photoresist. The laser process may also be effected in a reactive atmosphere, using gases such as oxygen, ozone, oxygen compounds, nitrogen trifluoride (NF₃), etc., to aid in the decomposition and removal of the photoresist.

Various methods are known in the art for localizing defects on patterned wafers. A summary of these methods is presented in an article entitled "Defect Detection on Patterned Wafers," in *Semiconductor International* (May 1997), pp. 64-70. There are many patents that describe methods and apparatus for defect localization, for example, U.S. Patents 5,264,912 and 4,628,531. Foreign particles are one type of defects that can be detected using these methods.

U.S. Patent 5,023,424 describes a method and apparatus using laser-induced shock waves to dislodge particles from a wafer surface. A particle detector is used to locate the positions of particles on the wafer surface. A laser beam is then focused at a point above the wafer surface near the position of each of the particles, in order to produce gas-borne shock waves with peak pressure gradients sufficient to dislodge and remove the particles. It is noted that the particles are dislodged by the shock wave, rather than vaporized due to absorption of the laser radiation. U.S. Patent 5,023,424 further notes that immersion of the surface in a liquid (as in the above-mentioned U.S. Patent 4,987,286, for example) is unsuitable for use in removing small numbers of microscopic particles.

Various methods are known in the art of surface contamination control using integrated cleaning. A summary of these methods is presented in an article entitled "Surface Contamination Control Using Integrated Cleaning" in *Semiconductor International* (June 1998), pp. 173-174, which is incorporated herein by reference,

Document WO 00/38935 discloses apparatus and method for removing particles from a substrate according to the pre-characterizing portions of the independent claims.

### SUMMARY OF THE INVENTION

Aspects of the present invention may be found in the appendant independent claims; embodiments of the present invention may be found in the appendant dependent claims, to which reference should now be made.

There is a desire to provide methods and apparatus for efficient removal of contaminants from solid-state surfaces, and particularly for removal of microscopic particles from semiconductor wafers and other elements used in semiconductor device production. The wafers may be bare, or they may have layers formed on their surface, whether patterned or unpatterned

It should be noted that a substrate is henceforth broadly defined as any solid-state surface such as a wafer, which requires at least one contaminant or particle to be removed from its surface. It should be noted further that the word particle is used broadly to define any contaminant or other element, which requires removal from a substrate surface.

There is also a desire to provide improved methods and apparatus for targeted removal of contaminant particles from a surface based on prior localization of the particles.

A cleaning module is employed to remove particles from a substrate surface. The cleaning module comprises a moving chuck, on which the substrate, is mounted, and a moving optical arm, positioned over the chuck. The chuck holds the substrate, most preferably by suction, and may comprise a motorized system which rotates the chuck about a theta (θ) axis or, alternatively, on x-y axes. The moving arm comprises optics, through which electromagnetic radiation, preferably a laser beam, is conveyed and directed onto the substrate to clean the substrate surface. The arm preferably rotates about a phi (Φ) axis passing through its base, parallel to but displaced from the θ axis of the chuck. Alternatively, the arm may move on x-y axes. The arm motion is coordinated with movement of the moving chuck so that the laser beam can be directed locally at any point on the wafer surface. The cleaning module may be connected to an electromagnetic energy source via a radiation guide, which is coupled to convey the energy to the optics of the moving arm. The cleaning module and laser module are herein termed a "particle removal unit".

In some preferred embodiments of the present invention, the arm further comprises channels for vapor or gas-phase transport to the substrate, and suction systems for transfer of gases and residuals from the substrate surface. In one such embodiment, vapor, preferably water vapor, is conveyed to the substrate via the channels in the cleaning arm. A vapor film is thus deposited onto the substrate, which condenses into a thin liquid film. Subsequently, when the electromagnetic energy impinges on the substrate, the liquid film evaporates explosively, as described, for example, in the above-mentioned U.S. Patent 4,987,286. The particle residuals and gas-phase matter are then preferably removed via the cleaning arm. The water vapor thus serves two purposes: to dislodge the particle from the substrate surface by explosive evaporation of the liquid, and to cool the substrate surface, so as to minimize damage.

In some preferred embodiments of the present invention, the particle removal unit is connected to a particle localization unit. The particle localization unit preferably provides the particle removal unit with the coordinates of one or more particles. The contaminated area of the substrate is positioned under the cleaning arm by moving both the substrate and the cleaning arm according the coordinates of the particle. Laser energy may be conveyed from the electromagnetic energy source, via the energy guide and the cleaning arm, and then targets the particle according to the information received from the particle localization unit The energy is fired so as to remove the particle from the substrate surface. The particle removal unit may lift the particle, preferably by suction, and convey it away from the substrate.

In some preferred embodiments of the present invention, the electromagnetic energy source comprises a multi-wavelength laser source. Preferably, the source combines ultraviolet laser radiation and infrared radiation, most preferably from an Optical Parametric Oscillator (OPO). The different wavelengths may be used individually or in combination, in order to match the energies required to remove a specific type of contaminant from a defined solid-state surface. The infrared radiation is preferably used in conjunction with the vapor film described above.

In some preferred embodiments of this invention, the particle removal unit is integrated into a metrology tool, cluster tool, or other process tool for microelectronics fabrication on a semiconductor wafer. Preferably, the cleaning module is connected to other processing units by an airless clean wafer transfer system. This integration of the cleaning module in the process system is made possible by the novel, compact design of the moving chuck and arm, making the cleaning module far more compact and non-intrusive than laser-based cleaning units known in the art. The proximity of the particle removal unit to a particle localization unit and/or to other process tools enables fast and effective removal of particles without adding a separate cleaning process step. This integrated laser cleaning reduces the amount of inter-step substrate handling, and thus reduces process time and costs and increases process yield.

### BRIEF DESCRIPTION OF THE FIGURES

The present invention will be more fully understood from the following detailed description of the preferred embodiments thereof, taken together with the drawings in which:
Fig. 1 is a schematic pictorial illustration of a particle removal unit, constructed and operative in accordance with a preferred embodiment of the present invention;
Fig. 2 is a schematic top view of a cleaning module used in the unit of Fig. 1, constructed and operative in accordance with a preferred embodiment of the present invention;
Fig. 3 is a schematic, sectional view of the cleaning module of Fig. 2, illustrating removal of a contaminant particle from the substrate;
Fig. 4 is a schematic, sectional view of the cleaning module of Fig. 2, showing further details of its construction;
Fig. 5. is a schematic, sectional view of a cleaning module for removal of particles from a substrate during a manufacturing process, in accordance with a preferred embodiment of the present invention;Fig. 6 is a graph showing a water absorption spectrum as a function of wavelength, useful in understanding a preferred embodiment of the present invention;
Fig. 7 is a simplified block diagram illustrating a laser source coupled to an optical parametric oscillator, constructed and operative in accordance with a preferred embodiment of the present invention;
Fig. 8 is a schematic view of a particle removal unit and a particle localization unit integrated into a semiconductor wafer processing cluster tool, constructed and operative in accordance with a preferred embodiment of the present invention;
Fig. 9 is a flow chart showing a method of substrate cleaning, in accordance with a preferred embodiment of the present invention; and
Fig. 10 is a flow chart showing a method of substrate cleaning, in accordance with another preferred embodiment of the present invention.

### DETAILED DESCRIPTION OF PREFERRED EMBODIMENTS

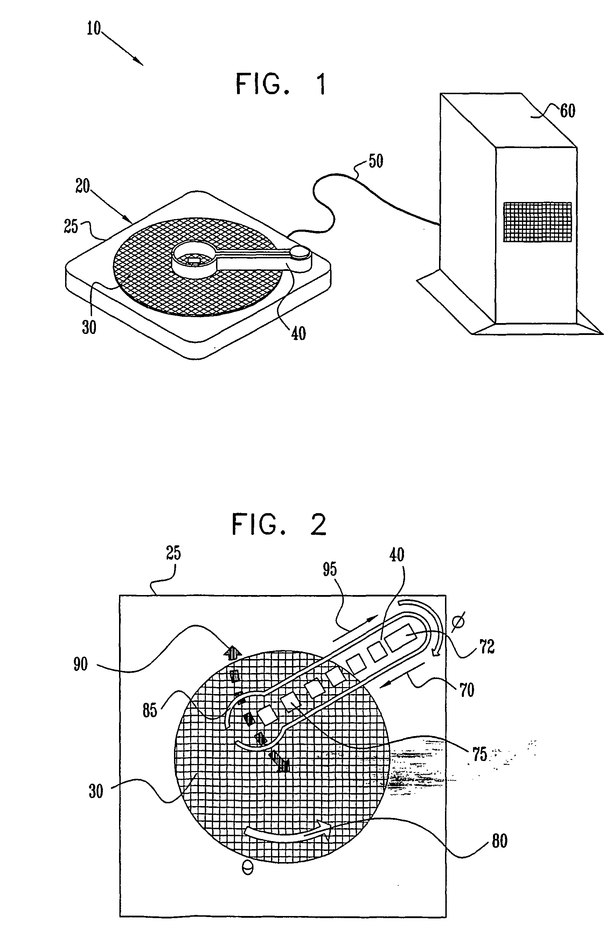

Fig. 1 is a schematic pictorial illustration of a particle removal unit 10, constructed and operative in accordance with a preferred embodiment of the present invention. Unit 10 comprises an *in situ* particle removal module 20, also referred to herein as a cleaning module. Module 20 comprises a substrate-holding chuck 25 on which a substrate 30 is mounted, and a cleaning arm 40. A multi-wavelength laser module 60 generates a laser beam, which is conveyed to arm 40 via a radiation guide 50.

Substrate 30 is preferably a semiconductor wafer, although the methods and apparatus described hereinbelow are similarly applicable to substrates of other kinds. Module 20 is preferably integrated *in situ* in a metrology or process tool or with other semiconductor processing equipment, as described hereinbelow. Laser module 60 is preferably remote from the process tool.

Fig. 2 is a schematic top view of module 20, in accordance with a preferred embodiment of this invention. Substrate 30 is placed on chuck 25, which rotates about a theta (θ) axis 80 at the center of the substrate. Arm 40 moves about a phi (φ) axis 90, which is parallel to but displaced from the θ axis. Arm 40 comprises optics 72 for conveying a laser beam 75 received via radiation guide 50 to the coordinates of a particle on substrate 30. The laser beam may be used in this manner to clean selected points on the substrate, which have been identified as the location of undesired particles, or to scan over and clean the entire substrate.

Preferably, arm 40 also comprises an inlet channel 70 for conveying gas or vapor to substrate 30. Additionally or alternatively, the arm comprises a suction channel 95 and a suction port 85 for removing particle debris, contaminants, liquid and gases from the area of the substrate. Suction port 85 comprises a nozzle, preferably constructed with an aperture of 0.5-3 cm diameter, most preferably 0.5 cm diameter. The nozzle is preferably positioned at a tilt of 25 to 60 degrees and a distance of up to 4 cm from the substrate surface, most preferably approximately 2 cm from the surface.

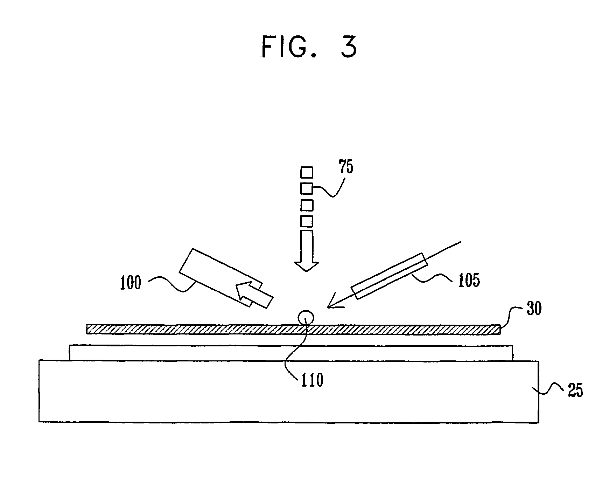

Fig. 3 is a schematic, sectional view showing details of module 20 and illustrating removal of a contaminant particle 110 from substrate 30. The laser beam is directed by optics in arm 40 onto the area in which particle 110 is located. A steam pulse is directed onto the area of the particle from inlet channel 70 before laser beam 75 is fired, with contaminated gas, liquid and solid products being removed simultaneously via suction port 85. Preferably, dry gas is conveyed via inlet channel 70 subsequent to the steam flow. The dry gas preferably impinges on substrate's 30 surface, and then preferably flows a suction nozzle (not shown) via tubing to the suction gas outlet 135. in order to dry the tubing.

In other preferred embodiments of this invention, suction is preferably started prior to activating the electromagnetic energy source, preferably laser. The time delay before activating the energy source is preferably 0 to 5 seconds, and most preferably, 0.5 seconds. This enables gas flow lines into the suction nozzle to form. Thereafter, when substrate 30 surface is irradiated, and one or more particles 110 are released, they exhibit a drift diffusion. The particle drift diffusion is controlled by the suction and dry gas flow rate.

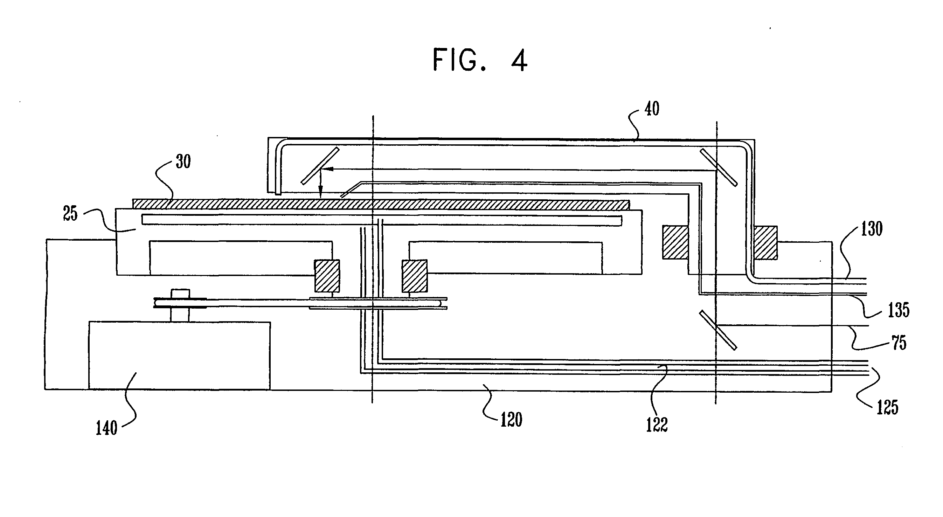

Fig. 4 is a schematic, sectional view of cleaning module 10, showing further details of its construction, in accordance with a preferred embodiment of the present invention. Substrate 30 is preferably held on chuck 25 by a suction mechanism 125. Preferably, a coolant channel 120 conveys a coolant 122, such as water, to chuck 25 in order to cool substrate 30, and thus to prevent thermal damage. Suction channel 95 is connected to a suction gas outlet 135. Rotation of chuck 25 is controlled by a motor 140. Although module 10 is shown here as an independent unit, in an alternative embodiment of the preferred embodiment, arm 40 is incorporated in an existing process chamber or metrology tool and makes use of a rotating chuck or X-Y stage that is already present in the system.

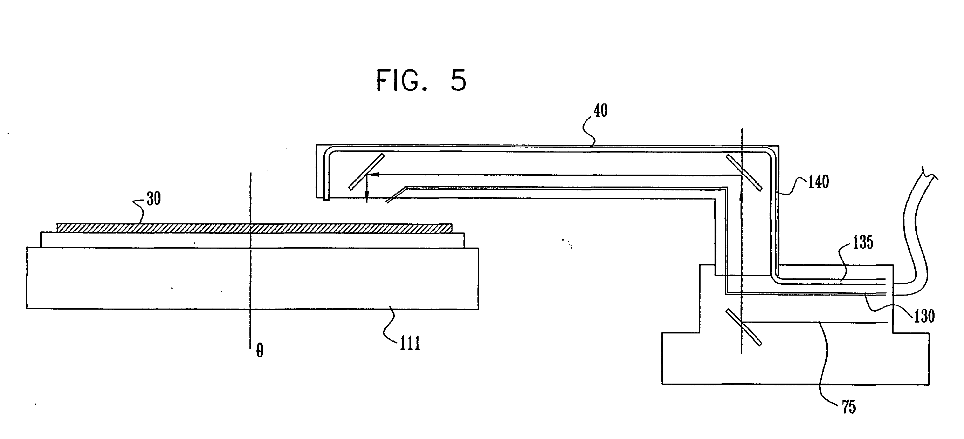

Fig. 5 is a schematic, sectional view of cleaning module 20, in accordance with another preferred embodiment of the present invention. In this embodiment, wafer 30 is mounted on an x-y stage or platform 111. Cleaning arm 40 may rotate about the φ axis, or it may be fixed, since the x-y stage allows the laser beam to reach all areas of the wafer surface without the necessity of scanning the laser beam, as well. The configuration of Fig. 5 is useful in the context of particle detection tools, which commonly include an x-y stage already.

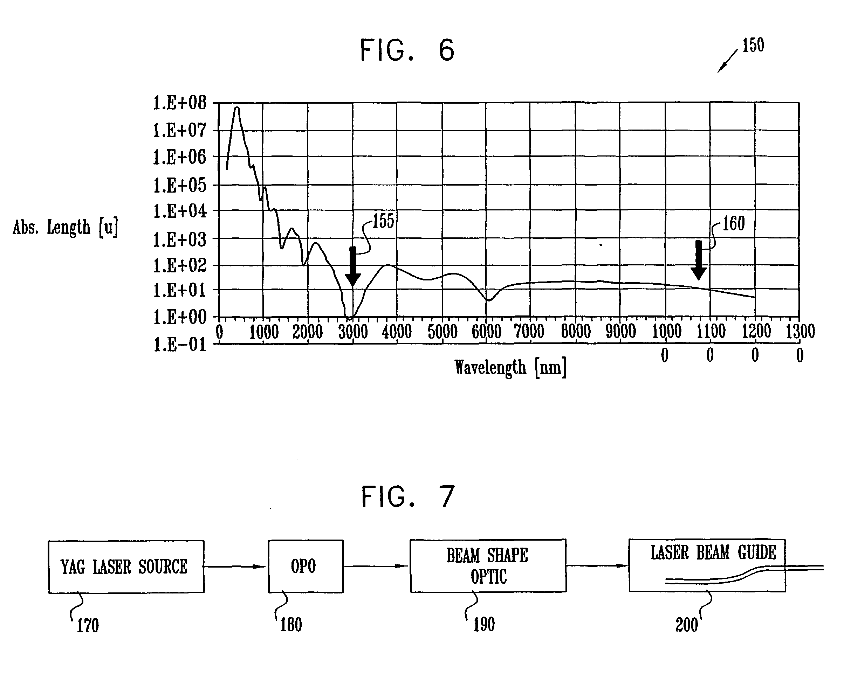

Fig. 6 is a graph showing a water absorption spectrum as a function of the wavelength of the incident radiation, useful in understanding aspects of the present invention. In order to achieve high absorption of the laser beam in a water film deposited on wafer 30, wavelengths of 10.6 µm and 2.95 µm are preferred, as they are points of strong absorption. The 2.95 µm absorption is more than one order of magnitude stronger than absorption at 10.6 µm. Preferably, laser module 60 is designed to generate a tuned, pulsed laser beam at wavelengths that are tailored according to the particular particle removal application, including both vapor-assisted and dry methods. Different process stages and contaminant types typically require different methods and different wavelengths for optimal cleaning. Thus, module 60 is preferably able to generate both ultraviolet and infrared (IR) radiation, which is most preferably tunable to the water absorption peak at 2.95 µm.

Fig. 7 is a simplified block diagram illustrating elements of multi-wavelength laser module 60, constructed and operative in accordance with a preferred embodiment of the present invention. A Nd:YAG laser source 170 emits a laser beam at 1.06 µm, which is directed into an optical parametric oscillator (OPO) 180. The OPO down-converts the laser frequency so as to emit a beam in the mid-IR, at one of the wavelengths at which water has an absorption peak, as shown in Fig. 6. Alternatively, a pulsed CO₂ laser (10.6 µm wavelength) can be used instead of the OPO. Beam shaping optics 190 direct the IR beam into radiation guide 50, which then carries the beam to arm 40. Preferably, module 60 also includes an ultraviolet (UV) laser, such as a Lambda Physik (Gottingen, Germany) LPX315 IMC excimer laser. The UV laser is highly efficient for cleaning bare silicon, while OPO 180 can generate radiation in the strong absorption region of water (2.95 µm) such that "explosive evaporation" conditions are reached and efficient particle cleaning achieved when UV cleaning is ineffective or unsatisfactory for other reasons.

In another preferred embodiment of this invention, the OPO and the UV laser operate simultaneously to deliver both IR and UV radiation. The OPO and laser are controlled in order to deliver radiation in amounts that will be sufficient for cleaning but below the damage threshold of the device. Proper control of the IR and UV sources enables particle removal with a lower total amount of energy imparted to substrate 30 than when only a single laser wavelength is used, as in systems known in the art. Lower energy deposition in the substrate reduces the possibility of thermal or radiation damage during cleaning.

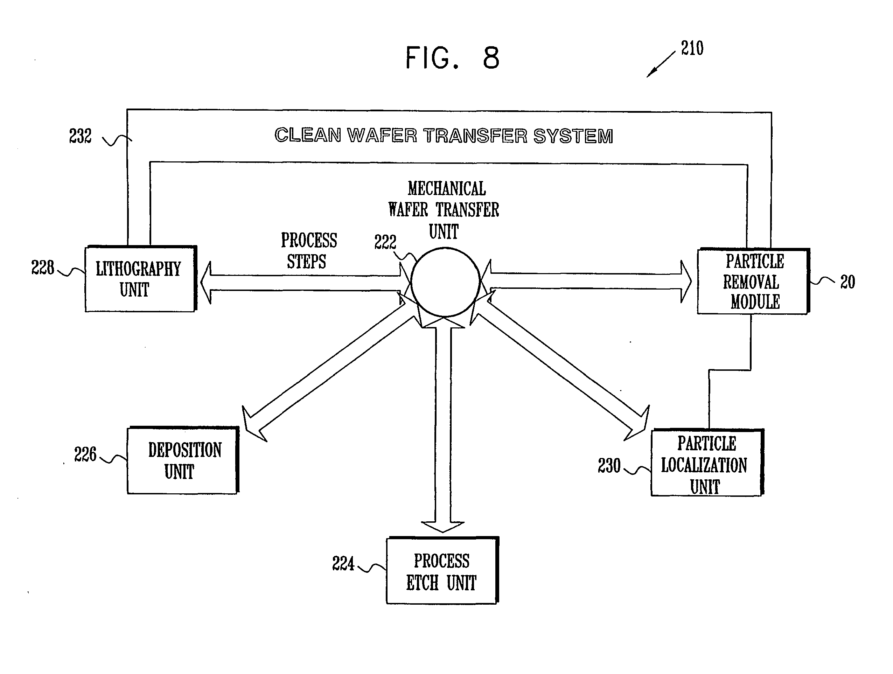

Fig. 8 schematically illustrates integration of particle removal unit 10 into a cluster tool 210 for semiconductor wafer processing, in accordance with a preferred embodiment of the present invention. Preferably, cluster tool 210 also comprises a particle localization unit 230, which is used to provide coordinates of particles that must be removed from wafer 30 by unit 10. A typical example of particle localization unit 230 is the KLA-Tencor "Surfscan" system.

Wafers are transferred to cleaning module 20 from other process elements in the cluster tool, in order to remove contaminants from the wafers before or after other processing steps. A mechanical wafer transfer unit 222 transfers wafer 30 via an airless clean wafer transfer system 232 to and from the other process elements. These typically include a process etch unit 224, a deposition unit 226, a lithography unit 228, and the like. After each process or cleaning step, mechanical wafer transfer unit 222 may transfer substrate 30 to the next process unit, or to particle localization unit to locate any further particles, and then to the cleaning module 20 to be cleaned again. When particle removal unit 10 receives information concerning the location of particles from particle localization unit 230, it can then perform very localized cleaning, and does not need to clean the whole wafer surface.

At the end of all the unit processes in the cluster tool, mechanical wafer transfer unit 222 transfers substrate 30 via airless clean wafer transfer system 232 to the cluster tool exit.

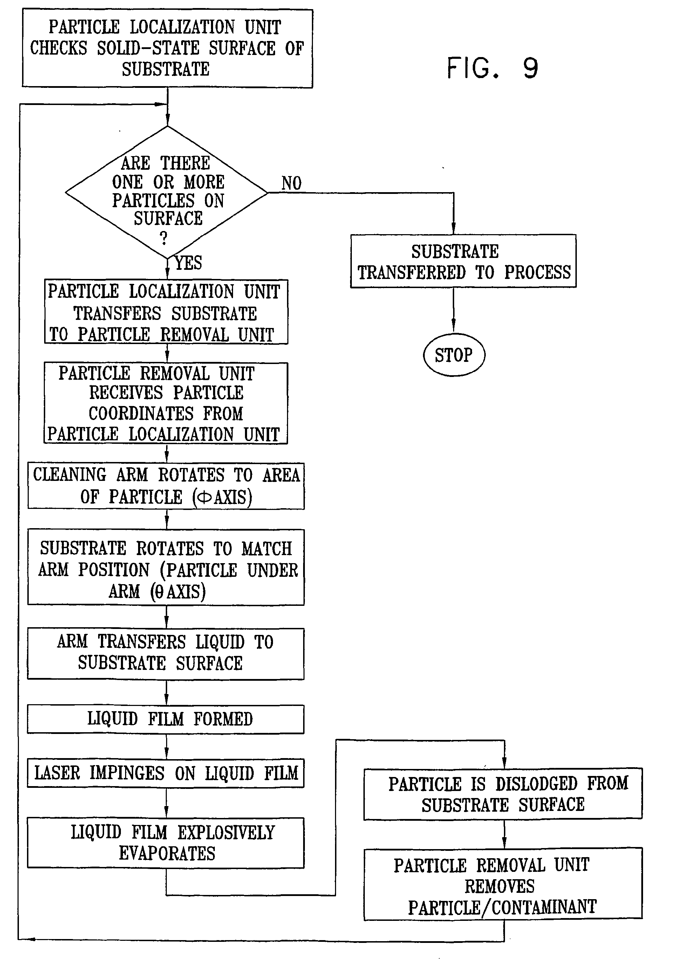

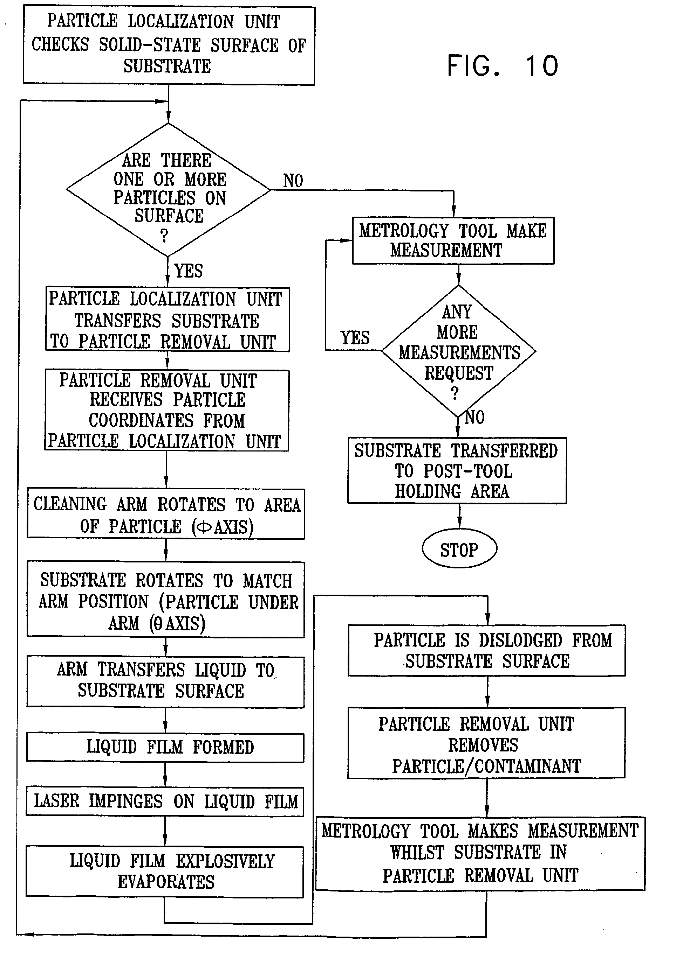

Thus, the laser-cleaning system comprising particle localization unit 230 and particle removal unit 10 can be used to clean a substrate *in situ.* This cleaning may take place at the front end of a process line [FEOL], at the back end of the line [BEOL], simultaneously with, during, or after a process, simultaneously with a measuring process, or prior, during, or after a measuring process. Process examples include, but are not limited to, pre-deposition, post-deposition, before and after lithography, development and etch processes, and before, during and after measurement processes. Two typical options are exemplified in Figs. 9 and 10.

Fig. 9 is a flow chart showing a typical sequence of substrate cleaning employing particle removal unit 10 *in situ* prior to a process in accordance with a preferred embodiment of the present invention. particle localization unit 230 checks substrate 30 surface for particle 110. Particle 110 may be external contaminant such as dust, microbe, photoresist residues from prior processing, and the like. When particle localization unit 230 finds one or more particles 110 on the surface of substrate 30, it transfers substrate 30 to particle removal unit 10. Particle localization unit 230 relays coordinates of particle 110 to particle removal unit 10. Preferably, cleaning arm 40 rotates about phi (φ) axis 90 to the area of particle 110 on substrate 30. Substrate 30, mounted on substrate chuck 25, may also move about theta (θ) axis 80 according to the coordinates of particle 110 received from particle localization unit 230.

Cleaning arm 40 then conveys steam 70 to the surface of substrate 30. The water vapor condenses on impact with substrate 30, and a liquid film is formed. The liquid film may cover parts or all of the surface of substrate 30. Laser beam 75, is conveyed from multi-wavelength laser module 60 via radiation guide 50 and through cleaning arm 40 onto the liquid film. The liquid film explosively evaporates, dislodging particle 110 from the surface of substrate 30. Particle 110 and/or particle remnants are preferably carried by airflow, or sucked into the channel in cleaning arm 40 and are ejected at suction gas outlet 135 of cleaning module 20.

The above process is repeated until all particles have been removed from the substrate surface.

Particle localization unit 230 preferably has electromechanical systems for substrate transfer. Substrate transfer may alternatively be manual, or be part of mechanical wafer transfer unit 222 of cluster tool 210. The wafer may be transferred to a holding stage or to another process unit, such as a process etch unit 224, a deposition unit 226, a lithography unit 228, or the like.

Fig. 10 is a flow chart illustrating a typical sequence of substrate cleaning employing particle removal unit 10 *in situ* simultaneously with a metrology process, in accordance with a preferred embodiment of the present invention. For example in a slow measuring process, such as microscopic measurement of dimensions of elements on substrate 30, or electrical measurements on a substrate, it is preferable to utilize the time to remove the particles simultaneously. The sequence of Fig. 10 is thus substantially similar to that of Fig. 9, except that in Fig. 10 the particle location and removal processes are interleaved, rather than serial. While unit 10 is operating, a metrology tool, such as a remote microscope, takes measurements of various elements on the surface of substrate 30, It is preferable that the movement of the microscope is coordinated with that of arm 40. The metrology tool continues to take measurements until all particles have been removed, and no more measurements are required.

It will be appreciated that the preferred embodiments described above are cited by way of example, and that the present invention is not limited to what has been particularly shown and described hereinabove. Rather, the scope of the present invention is defined by the appendant claims.

## Claims

1. Apparatus (10) for removing particles (110) from the surface of a substrate (30), comprising:
a moving chuck (25), which is configured to receive the substrate (30) and to move the substrate (30); and
a device, which is adapted to direct a beam of electromagnetic energy (75) onto the surface of the substrate (30), causing the particles (110) to be dislodged from the surface;
**characterized in that**:
the device is an optical arm (40) that is moveable, in cooperation with the movement of the chuck (25), in order to scan the beam (75) over the surface so as to impinge upon substantially any point on the surface from which the particles (110) are to be removed.

2. Apparatus (10) according to claim 1, wherein the apparatus (10) is adapted to receive input position coordinates of the particles (110) on the surface, and to direct the beam (75) by movement of the chuck (25) and the arm (40) so that the beam (75) is incident on the surface at the position coordinates of the particle (110).

3. Apparatus (10) according to claim 2, wherein the optical arm (40) is adapted to rotate about a base thereof so as to scan the beam (75) according to the particle (110) position coordinates.

4. Apparatus (10) according to claim 2 or 3, and comprising a particle localization unit (230), which is adapted to determine the input position coordinates.

5. Apparatus (10) according to any of the preceding claims, wherein the electromagnetic energy comprises laser energy.

6. Apparatus (10) according to claim 5, and comprising a laser module (60) adapted to generate the laser energy and a radiation guide (50) coupled from the laser module (60) to the optical arm (40) so as to supply the beam (75) of electromagnetic energy thereto.

7. Apparatus (10) according to claim 6, wherein the laser module (60) comprises a multi-wavelength laser module, which is adapted to supply the electromagnetic energy at a plurality of wavelengths.

8. Apparatus (10) according to claim 6 or 7, wherein the laser energy comprises infrared radiation.

9. Apparatus (10) according to any of claims 6-8, wherein the laser module (60) comprises an Optical Parametric Oscillator (O.P.O.) (180) which is tunable to match the energies required to remove a specific type of contaminant from the surface.

10. Apparatus (10) according to any of the preceding claims, wherein the optical arm (40) comprises a channel for conveying a vapor to the surface of the substrate.

11. Apparatus (10) according to claim 10, wherein the channel terminates in a nozzle adjacent to the substrate surface.

12. Apparatus (10) according to any of the preceding claims, wherein the optical arm (40) comprises an outlet channel, which is adapted to be coupled to a suction system.

13. Apparatus (10) according to claim 12, wherein the outlet channel comprises a suction nozzle adjacent to the substrate surface.

14. Apparatus (10) according to claim 13, wherein the suction nozzle has an aperture of approximately 0.5 to 3 cm.

15. Apparatus (10) according to claim 13 or 14, wherein suction nozzle is held no more than 4 cm above the substrate surface.

16. Apparatus (10) according to claim 15, wherein the suction nozzle is placed approximately 2 cm above the substrate surface.

17. Apparatus (10) according to any of the preceding claims, wherein the chuck (25) is adapted to rotate in a plane of the substrate (30) about a central axis thereof.

18. Apparatus (10) according to any of claims 1-16, wherein the chuck (25) is adapted to move linearly in a plane of the substrate (30) along x and y axes.

19. Apparatus (10) according to any of the preceding claims, wherein the arm (40) is adapted to rotate about a base thereof in a plane parallel to the substrate (30).

20. Apparatus (10) according to any of the preceding claims, wherein the substrate (30) comprises a semiconductor wafer.

21. A cluster tool (210) for processing a substrate (30) in the form of a semiconductor wafer, comprising:
a processing chamber, adapted to receive the wafer and comprising apparatus for forming microcircuit features on the wafer;
particle removing unit (20), adapted to receive the wafer and comprising the particle removal apparatus (10) according to any preceding claim; and
a wafer transfer mechanism (232), coupled to transfer the wafer between the processing chamber and the particle removal unit (20) substantially without exposing the wafer to ambient air.

22. A cluster tool (210) according to claim 21, wherein the particle removal unit (20) is adapted to receive input position coordinates of the particles (110) on the surface, and to direct the beam (75) responsive to the coordinates of the particles (110).

23. A cluster tool (210) according to claim 22, with the particle removing apparatus (10) of the particle removal unit (20) being dependent upon claim 4, wherein the wafer transfer mechanism (232) is adapted to transfer the wafer (30) to and from the particle localization unit (230) substantially without exposing the wafer (230) to ambient air.

24. A cluster tool (210) according to any of claims 21-23, wherein the particle removal unit (20) comprises a cleaning module, which is adapted to receive the wafen (30), and a laser module (60) and radiation guide (50), wherein the laser module (60) is situated remotely from the cleaning module and is coupled to the optical arm (40) by the radiation guide (50) so as to supply the beam of electromagnetic energy thereto.

25. A clusler tool (210) according to any of claims 21-24, wherein the optical arm (40) comprises one or more channels adapted to convey materials to or from the surface of the wafer (30).

26. A cluster tool (210) according to claim 25, wherein the one or more channels comprises a vapor channel, for conveying a vapor to the surface of the wafer 30.

27. A cluster tool (210) according to claim 25 or 26, wherein the one or more channels comprise a suction channel, for removal of contaminants from a vicinity of the wafer (30).

28. A method for removing particles (110) from the surface of a substrate (30), comprising:
positioning the substrate (30) under a device;
directing a beam (75) of electromagnetic energy through the device onto an area of the surface of the substrate (30), so as to dislodge particles (110) in the area from the surface; and
**characterized by**:
providing the device in the form of an optical arm (40); and
moving the optical arm (40) and the substrate (30) in cooperation so as to cause the beam (75) to impinge upon substantially any point on the surface from which the particles (110) are to be dislodged.

29. A method according to claim 28, and wherein moving the arm (40) and substrate (30) in cooperation comprises:
receiving input position coordinates of the particles (110) on the surface; and
positioning the arm (40) and substrate (30) in response to the input position coordinates.

30. A method according to claim 28 or 29, wherein the electromagnetic energy comprises laser energy.

31. A method according to claim 30, wherein directing the beam (75) of electromagnetic energy comprises coupling the optical arm (40) by a radiation guide (50) to a remote laser module (60).

32. A method according to claim 30 or 31, wherein directing the beam (75) of electromagnetic energy comprises supplying the laser energy at a plurality of wavelengths.

33. A method according to claim 32, wherein supplying the laser energy at the plurality of wavelengths comprises tuning the energy to a wavelength optimized for a particle removal process by which the particles (110) are to be dislodged.

34. A method according to claim 33, and comprising wetting the surface with a fluid before directing the beam (75) of electromagnetic energy, and wherein tuning the energy comprises tuning the wavelength to facilitate absorption of the energy by the fluid.

35. A method according to claim 34, wherein directing the beam (75) of electromagnetic energy comprises directing the beam (75) at the tuned wavelength with an energy sufficient to cause explosive evaporation of the fluid substantially without damage to the substrate (30).

36. A method according to any of claims 28-35, and comprising conveying a vapor to the surface of the substrate via the arm (40), wherein directing the beam (75) of electromagnetic. energy comprises directing the beam (75) onto the surface with an energy sufficient to cause explosive evaporation of the fluid substantially without damage to the substrate (30).

37. A method according to any of claims 28-36, and comprising applying suction via the arm (40) so as to remove matter from a vicinity of the substrate (30) surface.

38. A method according to any of claims 28-37, wherein moving the arm (40) and the substrate (30) comprises rotating the substrate (30) about a central axis thereof.

39. A method according to any of claims 28-37, wherein moving the arm (40) and the substrate (30) comprises moving the substrate (30) linearly in a plane of the substrate (30).

40. A method according to any of claims 28-39, wherein moving the arm (40) and the substrate (30) comprises rotating the arm (40) about an axis passing through a base thereof.

41. A method for processing a substrate (30) in the form of a semiconductor wafer, in a cluster tool (210), comprising:
forming microcircuit features on a surface of the wafer in a processing chamber;
transferring the wafer between the processing chamber and a particle removal unit (20) substantially without exposing the wafer to ambient air; and
removing particles (110) from the surface of the substrate (30) in accordance with the method of any of claims 28 to 40.

42. A method according to claim 41, and comprising receiving input position coordinates of the contaminants on the substrate (30) surface, wherein directing the beam (75) comprises aiming the beam (75) responsive to the input position coordinates.

43. A method according to claim 42, wherein receiving the input position coordinates comprises transferring the wafer (30) to a particle localization unit for determination of the coordinates, substantially without exposing the wafer (30) to ambient air.

44. A method according to any of claims 41-43, wherein directing the beam (75) comprises conveying the beam (75) via a radiation guide (50) from a remote laser module (60) to a cleaning module, which receives the wafer (30) without exposing the wafer (30) to the ambient air.

## Patentansprüche

1. Vorrichtung (10) zum Entfernen von Partikeln (110) von der Oberfläche eines Substrats (30), umfassend:
eine bewegliche Spannvorrichtung (25), die zur Annahme des Substrats (30) und zum Bewegen des Substrats (30) ausgelegt ist; und
eine Vorrichtung, die dafür geeignet ist, einen Strahl elektromagnetischer Energie (75) auf die Oberfläche des Substrats (30) zu richten, wodurch bewirkt wird, dass die Partikel (110) von der Oberfläche entfernt werden,
**dadurch gekennzeichnet, dass**:
die Vorrichtung ein optischer Arm (40) ist, der im Zusammenspiel mit der Bewegung der Spannvorrichtung (25) bewegbar ist, um den Strahl (75) über die Oberfläche streichen zu lassen, um auf im Wesentlichen jeden Punkt auf der Oberfläche aufzutreffen, von dem die Partikel (110) entfernt werden sollen.

2. Vorrichtung (10) nach Anspruch 1, wobei die Vorrichtung (10) geeignet ist, Eingabepositionskoordinaten der Partikel (110) auf der Oberfläche zu empfangen und den Strahl (75) durch Bewegung der Spannvorrichtung (25) und des Arms (40) zu lenken, sodass der Strahl (75) bei den Positionskoordinaten des Partikels (110) auf die Oberfläche auftrifft.

3. Vorrichtung (10) nach Anspruch 2, wobei der optische Arm (40) geeigent ist, um dessen Basis zu rotieren, um den Strahl (75) gemäß den Positionskoordinaten des Partikels (110) überstreichen zu lassen.

4. Vorrichtung (10) nach Anspruch 2 oder 3, umfassend eine Partikellokalisierungseinheit (230), die geeignet ist, die Eingabepositionskoordinaten zu bestimmen.

5. Vorrichtung (10) nach einem der vorhergehenden Ansprüche, wobei die elektromagnetische Energie Laserenergie umfasst.

6. Vorrichtung (10) nach Anspruch 5, umfassend ein Lasermodul (60), das geeignet ist, die Laserenergie zu erzeugen, und eine Strahlungsführung (50), die von dem Lasermodul (60) an den optischen Arm (40) gekoppelt ist, um diesem den Strahl (75) elektromagnetischer Energie bereit zu stellen.

7. Vorrichtung (10) nach Anspruch 6, wobei das Lasermodul (60) ein Lasermodul mit mehreren Wellenlängen umfasst, das geeignet ist, die elektromagnetische Energie mit einer Mehrzahl von Wellenlängen zu liefern.

8. Vorrichtung (10) nach Anspruch 6 oder 7, wobei die Laserenergie Infrarotstrahlung umfasst.

9. Vorrichtung (10) nach einem der Ansprüche 6 bis 8, wobei das Lasermodul (60) einen optisch parametrischen Oszillator (O. P. O.) (180) umfasst, der einstellbar ist, um die zum Entfernen einer speziellen Art von Kontaminat von einer Oberfläche erforderlichen Energien anzupassen.

10. Vorrichtung (10) nach einem der vorhergehenden Ansprüche, wobei der optische Arm (40) einen Kanal zum Zuführen eines Dampfes zu einer Oberfläche des Substrats umfasst.

11. Vorrichtung (10) nach Anspruch 10, wobei der Kanal in einem an der Substratoberfläche anliegenden Stutzen endet.

12. Vorrichtung (10) nach einem der vorhergehenden Ansprüche, wobei der optische Arm (40) einen Auslasskanal umfasst, der geeignet ist, an ein Absaugsystem gekoppelt zu werden.

13. Vorrichtung (10) nach Anspruch 12, wobei der Auslasskanal einen an der Substratoberfläche anliegenden Saugstutzen umfasst.

14. Vorrichtung (10) nach Anspruch 13, wobei der Saugstutzen eine Öffnung von etwa 0,5 bis 3 cm aufweist.

15. Vorrichtung (10) nach Anspruch 13 oder 14, wobei der Saugstutzen nicht mehr als 4 cm über der Substratoberfläche gehalten wird.

16. Vorrichtung (10) nach Anspruch 15, wobei der Saugstutzen etwa 2 cm über der Substratoberfläche platziert wird.

17. Vorrichtung (10) nach einem der vorhergehenden Ansprüche, wobei die Spannvorrichtung (25) geeignet ist, innerhalb einer Ebene des Substrats (30) um eine zentrale Achse davon zu rotieren.

18. Vorrichtung (10) nach einem der Ansprüche 1 bis 16, wobei die Spannvorrichtung (25) geeignet ist, sich linear in der Ebene des Substrats (30) entlang der x- und y-Achse zu bewegen.

19. Vorrichtung (10) nach einem der vorhergehenden Ansprüche, wobei der Arm (40) geeignet ist, um eine Basis davon in einer zu dem Substrat (30) parallelen Ebene zu rotieren.

20. Vorrichtung (10) nach einem der vorhergehenden Ansprüche, wobei das Substrat (30) einen Halbleiterwafer umfasst.

21. Ein Cluster-Werkzeug (210) zur Verarbeitung eines Substrats (30) in der Form eines Halbleiterwafers, umfassend:
eine Verarbeitungskammer, die geeignet ist, den Wafer aufzunehmen und die eine Vorrichtung zum Bilden von Mikroschaltkreismerkmalen auf dem Wafer umfasst;
Partikelentfernungseinheit (20), die geeignet ist, den Wafer aufzunehmen und die die Partikelentfernungsvorrichtung (10) gemäß einem der vorherigen Ansprüche umfasst; und
einen Waferübergabemechanismus (232), der angekoppelt ist, um den Wafer zwischen der Verarbeitungskammer und der, Partikelentfernungseinheit (20) zu überführen, wobei der Wafer im Wesentlichen nicht der Umgebungsluft ausgesetzt wird.

22. Ein Cluster-Werkzeug (210) nach Anspruch 21, wobei die Partikelenifernungseinheit (20) geeignet ist, Eingabepositionskoordinaten der Partikel (110) auf der Oberfläche zu empfangen und den Strahl (75) in Antwort auf die Koordinaten der Partikel (110) zu richten.

23. Ein Cluster-Werkzeug (210) nach Anspruch 22, mit der Partikelentfernungsvorrichtung (10) entsprechend Anspruch 4 der Partikelentfernungseinheit (20), wobei der Waferubergabemechanismus (232) geeignet ist, den Wafer (30) zu und von der Partikellokalisierungseinheit (230) zu überführen, wobei der Wafer (230) im Wesentlichen der Umgebungsluft nicht ausgesetzt wird.

24. Ein Cluster-Werkzeug (210) nach einem der Ansprüche 21 bis 23, wobei die Partikelentfernungseinheit (20) ein Reinigungsmodul, das geeignet ist, den Wafer (30) aufzunehmen, und ein Lasermodul (60) und eine Strahlungsführung (50) umfasst, wobei sich das Lasermodul (60) entfernt von dem Reinigungsmodul befindet und an den optischen Arm (40) durch die Strahlungsführung angekoppelt ist, um diesem den Strahl elektromagnetischer Energie bereit zu stellen.

25. Ein Cluster-Werkzeug (210) nach einem der Ansprüche 21 bis 24, wobei der optische Arm (40) einen oder mehr Kanäle umfasst, die geeignet sind, Materialien zu oder von der Oberfläche des Wafers (30) zu transportieren.

26. Ein Cluster-Werkzeug (210) nach Anspruch 25, wobei der eine oder die mehreren Kanäle einen Dampfkanal, zur Überführung eines Dampfes zu der Oberfläche eines Wafers (30), umfassen.

27. Ein Cluster-Werkzeug (210) nach Anspruch 25 oder 26, wobei der eine oder die mehreren Kanäle einen Absaugkanal zum Entfernen von Kontaminaten aus einer Umgebung des Wafers (30) umfassen.

28. Ein Verfahren zum Entfernen von Partikeln (110) von der Oberfläche eines Substrats (30), umfassend
Positionieren des Substrats (30) unter einer Vorrichtung;
Richten eines Strahls (75) elektromagnetischer Energie durch die Vorrichtung auf eine Fläche auf der Oberfläche des Substrats (30), um Partikel (110) von der Fläche der Oberfläche zu entfernen;
**Gekennzeichnet durch**
Bereitstellen der Vorrichtung in der Form eines optischen Arms (40); und
Bewegen des optischen Arms (40) und des Substrats (30) im Zusammenspiel, um den Strahl (75) zu veranlassen auf im Wesentlichen jeden Punkt auf der Oberfläche aufzutreffen, von dem die Partikel (110) entfernt werden sollen.

29. Ein Verfahren nach Anspruch 28, wobei Bewegen des Arms (40) und des Substrats (30) im Zusammenspiel umfasst:
Empfangen der Eingabepositionskoordinaten der Partikel (110) auf der Oberfläche; und
Positionieren des Arms (40) und des Substrats (30) in Antwort auf die Eingabepositionskoordinaten.

30. Ein Verfahren nach Anspruch 28 oder 29, wobei die elektromagnetische Energie Laserenergie umfasst.

31. Ein Verfahren nach Anspruch 30, wobei Ausrichten eines Strahls (75) elektromagnetischer Energie Koppeln des optischen Arms (40) an ein entferntes Lasermodul (60) durch eine Strahlungsführung (50) umfasst.

32. Ein Verfahren nach Anspruch 30 oder 31, wobei Ausrichten des Strahls (75) elektromagnetischer Energie Zufuhren der Laserenergie mit einer Vielzahl von Wellenlängen umfasst.

33. Ein Verfahren nach Anspruch 32, wobei Zuführen der Laserenergie mit einer Vielzahl von Wellenlängen Abstimmen der Energie auf eine für einen Partikelentfernungsprozess, durch den die Partikel (110) entfernt werden sollen, optimierte Wellenlänge umfasst.

34. Ein Verfahren nach Anspruch 33, umfassend Benetzen der Oberfläche mit einem Fluid vor Ausrichten des Strahls (75) elektromagnetischer Strahlung und wobei Abstimmen der Energie ein Abstimmen der Wellenlänge zum Ermöglichen der Absorption von Energie durch das Fluid umfasst.

35. Ein Verfahren nach Anspruch 34, wobei ein Ausrichten des Strahls (75) elektromagnetischer Strahlung ein Ausrichten des Strahls (75) der abgestimmten Wellenlänge mit einer zum Hervorrufen einer explosiven Evaporation des Fluids ausreichenden Energie, ohne das Substrat (30) wesentlich zu schädigen, umfasst.

36. Ein Verfahren nach einem der Ansprüche 28 bis 35, umfassend Zuführen eines Dampfes zu der Oberfläche des Substrats über den Arm (40), wobei ein Ausrichten des Strahls (75) elektromagnetischer Energie das Ausrichten des Strahls (75) auf die Oberfläche mit einer zum Hervorrufen einer explosiven Evaporation des Fluids ausreichenden Energie, ohne das Substrat (30) wesentlich zu schädigen, umfasst.

37. Ein Verfahren nach einem der Ansprüche 28 bis 36, umfassend Anwenden von Absaugen durch den Arm (40) um Materie aus einer Umgebung der Oberfläche des Substrats (30) zu entfernen.

38. Ein Verfahren nach einem der Ansprüche 28 bis 37, wobei ein Bewegen des Arms (40) und des Substrats (30) das Rotieren des Substrats (30) um dessen zentrale Achse umfasst.

39. Ein Verfahren nach einem der Ansprüche 28 bis 37, wobei ein Bewegen des Arms (40) und des Substrats (30) ein lineares Bewegen des Substrats (30) in einer Ebene des Substrats (30) umfasst.

40. Ein Verfahren nach einem der Ansprüche 28 bis 39, wobei ein Bewegen des Arms (40) und des Substrats (30) ein Rotieren des Arms (40) um eine durch dessen Basis gehende Achse umfasst.

41. Ein Verfahren zur Verarbeitung eines Substrats (30) in der Form eines Halbleiterwafers, in einem Cluster-Werkzeug (210), umfassend:
Bilden von Mikroschaltkreismerhalen auf einer Oberfläche des Wafers in einer Verarbeitungskammer;
Überführen des Wafers zwischen der Verarbeitungskammer und einer Partikelentfernungseinheit (20), wobei der Wafer im Wesentlichen nicht der Umgebungsluft ausgesetzt wird; und
Entfernen von Partikeln (110) von der Oberfläche des Substrates (30) gemäß dem Verfahren nach einem der Ansprüche 28 bis 40.

42. Ein Verfahren nach Anspruch 41, umfassend ein Empfangen von Eingabepositionskoordinaten der Kontaminate auf der Oberfläche des Substrats (30), wobei ein Ausrichten des Strahls (75) ein Zielen des Strahls (75) in Antwort auf die Eingabepositionskoordinaten umfasst.

43. Ein Verfahren nach Anspruch 42, wobei das Empfangen der Eingabepositionskoordinaten ein Überführen des Wafers (30) an die Partikellokalisierungseinheit zur Bestimmung der Koordinaten umfasst, wobei der Wafer (30) im Wesentlichen nicht der Umgebungsluft ausgesetzt wird.

44. Ein Verfahren nach einem der Ansprüche 41 bis 43, wobei das Ausrichten des Strahls (75) ein Zuführen des Strahls (75) über eine Stahlungsführung (50) von einem entfernten Lasermodul (60) zu einem Reinigungsmodul umfasst, das den Wafer (30), ohne den Wafer (30) der Umgebungsluft auszusetzen, aufnimmt.

## Revendications

1. Appareil (10) pour éliminer des particules (110) de la surface d'un substrat (30), comprenant :
un plateau de maintien mobile (25) qui est configuré pour recevoir le substrat (30) et pour déplacer le substrat (30) ; et
un dispositif qui est adapté pour diriger un faisceau d'énergie électromagnétique (75) sur la surface du substrat (30), ce qui provoque le déplacement des particules (110) de la surface ;
**caractérisé en ce que** :
le dispositif est un bras optique (40) qui est mobile, en coopération avec le mouvement du plateau de maintien (25), afin de balayer le faisceau (75) sur la surface afin de frapper sensiblement n'importe quel point sur la surface à partir de laquelle les particules (110) doivent être éliminées.

2. Appareil (10) selon la revendication 1, dans lequel l'appareil (10) est adapté pour recevoir des coordonnées de position d'entrée des particules (110) sur la surface et pour diriger le faisceau (75) avec le mouvement du support de maintien (25) et du bras (40), de telle sorte que le faisceau (75) ait une incidence sur la surface aux coordonnées de position des particules (110).

3. Appareil (10) selon la revendication 2, dans lequel le bras optique (40) est adapté pour tourner autour de sa base afin de balayer le faisceau (75) selon les coordonnées de position des particules (110).

4. Appareil (10) selon la revendication 2 ou 3 et comprenant une unité de localisation des particules (230) qui est adaptée pour déterminer les coordonnées de position d'entrée.

5. Appareil (10) selon l'une quelconque des revendications précédentes, dans lequel l'énergie électromagnétique comprend l'énergie laser.

6. Appareil (10) selon la revendication 5 et comprenant un module laser (60) adapté pour générer l'énergie laser et un guide de rayonnement (50) couplé du module laser (60) au bras optique (40) afin d'émettre le faisceau (75) d'énergie électromagnétique vers celui-ci.

7. Appareil (10) selon la revendication 6, dans lequel le module laser (60) comprend un module laser multilongueur d'onde qui est adapté pour émettre l'énergie électromagnétique à une pluralité de longueurs d'onde.

8. Appareil (10) selon la revendication 6 ou 7, dans lequel l'énergie laser comprend un rayon infrarouge.

9. Appareil (10) selon l'une quelconque des revendications 6 à 8, dans lequel le module laser (60) comprend un oscillateur paramétrique optique (OPO) (180) qui est réglable pour correspondre aux énergies nécessaires pour éliminer de la surface un type spécifique de contaminant.

10. Appareil (10) selon l'une quelconque des revendications précédentes, dans lequel le bras optique (40) comprend un canal pour transporter de la vapeur vers la surface du substrat.

11. Appareil (10) selon la revendication 10, dans lequel le canal se termine dans une buse adjacente à la surface du substrat.

12. Appareil (10) selon l'une quelconque des revendications précédentes, dans lequel le bras optique (40) comprend un canal d'évacuation qui est adapté pour être couplé à un système d'aspiration.

13. Appareil (10) selon la revendication 12, dans lequel le canal d'évacuation comprend une buse d'aspiration adjacente à la surface du substrat.

14. Appareil (10) selon la revendication 13, dans lequel la buse d'aspiration a une ouverture d'approximativement 0,5 à 3 cm.

15. Appareil (10) selon la revendication 13 ou 14, dans lequel la buse d'aspiration est maintenue au plus à 4 cm au-dessus de la surface du substrat.

16. Appareil (10) selon la revendication 15, dans lequel la buse d'aspiration est placée approximativement 2 cm au-dessus de la surface du substrat.

17. Appareil (10) selon l'une quelconque des revendications précédentes, dans lequel le support de maintien (25) est adapté pour tourner dans un plan du substrat (30) autour de son axe central.

18. Appareil (10) selon l'une quelconque des revendications 1 à 16, dans lequel le support de maintien (25) est adapté pour se déplacer linéairement dans un plan du substrat (30) le long des axes x et y.

19. Appareil (10) selon l'une quelconque des revendications précédentes, dans lequel le bras (40) est adapté pour tourner autour de sa base dans un plan parallèle au substrat (30).

20. Appareil (10) selon l'une quelconque des revendications précédentes, dans lequel le substrat (30) comprend une tranche de semi-conducteur.

21. Outil combiné (210) pour le traitement d'un substrat (30) sous la forme d'une tranche de semi-conducteur, comprenant :
une chambre de traitement adaptée pour recevoir la tranche et comprenant un appareil pour former des caractéristiques de microcircuit sur la tranche ;
une unité d'élimination des particules (20) adaptée pour recevoir la tranche et comprenant l'appareil d'élimination des particules (10) selon l'une quelconque des revendications précédentes ; et
un mécanisme de transfert de tranche (232) couplé pour transférer la tranche entre la chambre de traitement et l'unité d'élimination des particules (20) sensiblement sans exposer la tranche à l'air ambiant.

22. Outil combiné (210) selon la revendication 21, dans lequel l'unité d'élimination des particules (20) est adaptée pour recevoir les coordonnées de position d'entrée des particules (110) sur la surface et diriger le faisceau (75) sensible aux coordonnées des particules (110).

23. Outil combiné (210) selon la revendication 22 avec un appareil (10) pour éliminer les particules, de l'unité d'élimination des particules (20), dépendant de la revendication 4, dans lequel le mécanisme de transfert de tranche (232) est adapté pour transférer la tranche (30) vers et depuis l'unité de localisation des particules (230) sensiblement sans exposer la tranche (230) à l'air ambiant.

24. Outil combiné (210) selon l'une quelconque des revendications 21 à 23, dans lequel l'unité d'élimination des particules (20) comprend un module de nettoyage qui est adapté pour recevoir la tranche (30) et un module laser (60) et un guide de rayonnement (50), dans lequel le module laser (60) est situé à distance du module de nettoyage et couplé au bras optique (40) par le guide de rayonnement (50) afin d'émettre le faisceau d'énergie électromagnétique sur celui-ci.

25. Outil combiné (210) selon l'une quelconque des revendications 21 à 24, dans lequel le bras optique (40) comprend un ou plusieurs canaux adaptés pour transporter les matériaux vers et depuis la surface de la tranche (30).

26. Outil combiné (210) selon la revendication 25, dans lequel les un ou plusieurs canaux comprennent un canal pour la vapeur afin de transporter de la vapeur sur la surface de la tranche (30).

27. Outil combiné (210) selon la revendication 25 ou 26, dans lequel les un ou plusieurs canaux comprennent un canal d'aspiration pour éliminer les contaminants aux environs de la tranche (30).

28. Procédé pour éliminer les particules (110) de la surface d'un substrat (30), comprenant :
le placement du substrat (30) sous un dispositif ;
l'orientation d'un faisceau (75) d'énergie électromagnétique traversant le dispositif sur une zone de la surface du substrat (30) afin de déplacer les particules (110) dans la zone de la surface ; et
**caractérisé par** le fait de :
proposer le dispositif sous la forme d'un bras optique (40) ; et de
déplacer le bras optique (40) et le substrat (30) en coopération pour que le faisceau (75) frappe sensiblement n'importe quel point sur la surface à partir de laquelle les particules (110) doivent être éliminées.

29. Procédé selon la revendication 28, dans lequel le déplacement du bras (40) et du substrat (30) en coopération comprend :
la réception des coordonnées de position d'entrée des particules (110) sur la surface ; et
le positionnement du bras (40) et du substrat (30) en réponse aux coordonnées de position d'entrée.

30. Procédé selon la revendication 28 ou 29, dans lequel l'énergie électromagnétique comprend l'énergie laser.

31. Procédé selon la revendication 30, dans lequel l'orientation du faisceau (75) d'énergie électromagnétique comprend le couplage du bras optique (40) par un guide de rayonnement (50) à un module laser à distance (60).

32. Procédé selon la revendication 30 ou 31, dans lequel l'orientation du faisceau (75) d'énergie électromagnétique comprend l'émission de l'énergie laser à une pluralité de longueurs d'onde.

33. Procédé selon la revendication 32, dans lequel l'émission de l'énergie laser à la pluralité de longueurs d'onde comprend le réglage de l'énergie à une longueur d'onde optimisée pour un processus d'élimination des particules au moyen duquel les particules (110) doivent être déplacées.

34. Procédé selon la revendication 33 et comprenant l'humidification de la surface avec un fluide avant de diriger le faisceau (75) d'énergie électromagnétique et dans lequel le réglage de l'énergie comprend le réglage de la longueur d'onde pour faciliter l'absorption de l'énergie par le fluide.

35. Procédé selon la revendication 34, dans lequel l'orientation du faisceau (75) d'énergie électromagnétique comprend l'orientation du faisceau (75) à la longueur d'onde réglée avec une énergie suffisante pour entraîner l'évaporation explosive du fluide sensiblement sans endommager le substrat (30).

36. Procédé selon l'une quelconque des revendications 28 à 35 et comprenant le transport de vapeur jusqu'à la surface du substrat via le bras (40), dans lequel l'orientation du faisceau (75) d'énergie électromagnétique comprend l'orientation du faisceau (75) sur la surface avec une énergie suffisante pour entraîner l'évaporation explosive du fluide sensiblement sans endommager le substrat (30).

37. Procédé selon l'une quelconque des revendications 28 à 36 et comprenant l'application d'une aspiration *via* le bras (40) afin d'éliminer toute matière des environs de la surface du substrat (30).

38. Procédé selon l'une quelconque des revendications 28 à 37, dans lequel le bras (40) et le substrat (30) comprennent la rotation du substrat (30) autour de son axe central.

39. Procédé selon l'une quelconque des revendications 28 à 37, dans lequel le déplacement du bras (40) et du substrat (30) comprend le déplacement du substrat (30) linéairement dans un plan du substrat (30).

40. Procédé selon l'une quelconque des revendications 28 à 39, dans lequel le bras (40) et le substrat (30) comprennent la rotation du bras (40) autour d'un axe traversant sa base.

41. Procédé pour traiter un substrat (30) sous la forme d'une tranche de semi-conducteur, dans un outil combiné (210), comprenant :
la formation de caractéristiques de microcircuit sur une surface de la tranche dans une chambre de traitement ;
le transfert de la tranche entre la chambre de traitement et une unité d'élimination des particules (20) sensiblement sans exposer la tranche à l'air ambiant ; et
l'élimination des particules (110) de la surface du substrat (30) conformément au procédé selon l'une quelconque des revendications 28 à 40.

42. Procédé selon la revendication 41 et comprenant la réception des coordonnées de position d'entrée des contaminants sur la surface du substrat (30), dans lequel l'orientation du faisceau (75) comprend le pointage du faisceau (75) sensible aux coordonnées de position d'entrée.

43. Procédé selon la revendication 42, dans lequel la réception des coordonnées de position d'entrée comprend le transfert de la tranche (30) vers une unité de localisation des particules pour déterminer les coordonnées, sensiblement sans exposer la tranche (30) à l'air ambiant.

44. Procédé selon l'une quelconque des revendications 41 à 43, dans lequel l'orientation du faisceau (75) comprend le transport du faisceau (75) *via* un guide de rayonnement (50) d'un module laser à distance (60) vers un module de nettoyage, qui reçoit la tranche (30) sans exposer la tranche (30) à l'air ambiant.
